(19) Europäisches Patentamt / European Patent Office / Office européen des brevets

(11) **EP 3 891 647 B1**

(12) **FASCICULE DE BREVET EUROPEEN**

(45) Date de publication et mention
de la délivrance du brevet:
**19.06.2024   Bulletin 2024/25**

(21) Numéro de dépôt: **19823801.6**

(22) Date de dépôt: **19.11.2019**

(51) Classification Internationale des Brevets (IPC):
$G06F\ 30/17^{(2020.01)}$    $B60T\ 8/88^{(2006.01)}$
$G01H\ 13/00^{(2006.01)}$    $G06F\ 30/20^{(2020.01)}$

(52) Classification Coopérative des Brevets (CPC):
**B60T 8/885; G01H 13/00; G06F 30/17; G06F 30/20**

(86) Numéro de dépôt international:
**PCT/FR2019/052753**

(87) Numéro de publication internationale:
**WO 2020/115386 (11.06.2020 Gazette 2020/24)**

(54) **PRÉDICTION D'INSTABILITÉ DE CRISSEMENT POUR UN FREIN DE VÉHICULE**

VORHERSAGE DER QUIETSCHINSTABILITÄT FÜR EINE FAHRZEUGBREMSE

PREDICTION OF SQUEAL INSTABILITY FOR A VEHICLE BRAKE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **03.12.2018   FR 1872222**

(43) Date de publication de la demande:
**13.10.2021   Bulletin 2021/41**

(73) Titulaires:
  • **Stellantis Auto SAS**
    **78300 Poissy (FR)**
  • **Centre National de la Recherche Scientifique**
    **75016 Paris Cedex 16 (FR)**
  • **Ecole Centrale de Lyon**
    **69134 Ecully Cedex (FR)**
  • **Ecole Nationale d'Ingénieurs de Saint-Etienne**
    **42100 Saint-Etienne (FR)**
  • **Ecole Nationale Travaux Publics de l'Etat**
    **69120 Vaulx-en-Velin (FR)**

(72) Inventeurs:
  • **DENIMAL, Enora**
    **44130 Blain (FR)**
  • **NACIVET, Samuel**
    **75018 Paris (FR)**
  • **SINOU, Jean-Jacques**
    **69003 Lyon (FR)**

(56) Documents cités:
  • **NACIVET S ET AL: "Modal Amplitude Stability Analysis and its application to brake squeal", APPLIED ACOUSTICS, ELSEVIER PUBLISHING, GB, vol. 116, 26 septembre 2016 (2016-09-26), pages 127-138, XP029788733, ISSN: 0003-682X, DOI: 10.1016/J.APACOUST.2016.09.010 cité dans la demande**
  • **SINOU ET AL: "Transient non-linear dynamic analysis of automotive disc brake squeal On the need to consider both stability and non-linear analysis", MECHANICS RESEARCH COMMUNICATIONS, PERGAMON, AMSTERDAM, NL, vol. 37, no. 1, 1 janvier 2010 (2010-01-01), pages 96-105, XP026894659, ISSN: 0093-6413, DOI: 10.1016/J.MECHRESCOM.2009.09.002 [extrait le 2009-09-23]**
  • **E. Denimal ET AL: "Kriging Surrogate Models for Predicting the Complex Eigenvalues of Mechanical Systems Subjected to Friction-Induced Vibration", SHOCK AND VIBRATION, vol. 2016, 1 janvier 2016 (2016-01-01), pages 1-22, XP055614410, NL ISSN: 1070-9622, DOI: 10.1155/2016/3586230**

**Description**

Domaine technique de l'invention

La présente invention concerne une méthode et un dispositif de prédiction d'instabilité de crissement pour un système de frein, présentant au moins une surface de friction, par exemple un frein de véhicule à disque, à tambour, etc.

Il est difficile de prédire l'apparition d'un bruit de crissement suffisamment tôt pour réduire les coûts de développement dans le processus de fabrication d'un système de freinage. Par conséquent le crissement est toujours responsable d'un nombre important de nuisances dans le domaine de l'automobile et le problème de la prédiction du bruit de crissement et de la compréhension des mécanismes (instabilités) à son origine sont actuellement un enjeu pour les industriels de l'automobile.

Etat de la technique

La littérature recense de nombreuses méthodes pour l'étude des systèmes dynamiques non-linéaires. Le choix de la méthode se fait selon certains critères tels que le type de non-linéarités impliquées ou encore le type de solution recherchée. En effet, ce ne sont pas les mêmes outils et les mêmes formalismes qui sont utilisés pour traiter des non-linéarités régulières ou non, fortes ou faibles, avec ou sans hystérésis et des solutions périodique, quasi-périodique, transitoire ou chaotique.

Dans le cadre du crissement, il est nécessaire d'utiliser des méthodes permettant de traiter des systèmes autonomes non-linéaires dont les réponses sont souvent considérées comme étant périodiques ou quasi-périodiques. La taille des systèmes étudiés, les non-linéarités impliquées et les différents couplages rendent la résolution analytique des équations associées difficilement inenvisageable.

Parmi les méthodes numériques en mesure d'analyser ces systèmes, certaines permettent cependant de statuer sur la stabilité de la position d'équilibre, comme par exemple, la méthode CEA (« Complex Eigenvalue Analysis ») qui met en oeuvre une analyse en valeur propre classique au voisinage de l'équilibre statique non-linéaire. Cette méthode est décrite de manière générale par exemple dans le document de MOIROT, Franck. intitulé « Etude de la stabilité d'un équilibre en présence de frottement de Coulomb. Application au crissement des freins à disque ». (1998, Thèse de doctorat, Palaiseau, Ecole polytechnique).

La méthode CEA consiste à déterminer les valeurs propres du système autour de sa position d'équilibre afin de statuer sur la stabilité de ce point d'équilibre. Les modes qui possèdent une valeur propre à partie réelle positive sont considérés comme instables puisqu'une légère perturbation de l'équilibre entrainera un taux d'accroissement positif des oscillations associées à ces modes.

Cette méthode CEA est relativement simple à mettre en oeuvre et ses résultats sont faciles à analyser puisque les modes instables identifiés sont potentiellement les modes instables présents dans la réponse dynamique du système. Cependant, la méthode CEA est souvent surou sous-prédictive, c'est-à-dire que l'ensemble des modes instables identifiés par la méthode CEA ne sont pas nécessairement présents dans la réponse dynamique et que la réponse dynamique peut comprendre des modes instables (i.e. fréquences) non identifiées par la méthode CEA, correspondant à l'émergence de nouvelles instabilités.

Il apparaît ainsi un besoin de trouver un critère et/ou une méthode permettant d'identifier dans la réponse dynamique du système de frein les modes instables qui sont responsables du crissement à partir des résultats de la méthode CEA.

Par ailleurs, la méthode CEA permet uniquement d'identifier des modes potentiellement impliqués dans la réponse dynamique, mais elle ne donne aucune indication sur les niveaux vibratoires et les fréquences d'excitation du système.

Ainsi l'obtention de la réponse dynamique et des niveaux vibratoires associés doit toutefois se faire avec d'autres méthodes numériques qui viennent compléter la méthode CEA et qui permettent d'approximer la réponse dynamique, en termes notamment de niveaux vibratoires et de fréquences d'excitation du système.

La méthode MASA (Modal Amplitude Stability Analysis) a pour objectif de fournir une analyse complémentaire à la CEA. La méthode MASA est décrite de manière générale dans le document de NACIVET, S. et J.-J. SINOU. 2017, intitulé «Modal amplitude stability analysis and its application to brake squeal», Applied Acoustics, vol. 116, p. 127-138.

La MASA permet de déterminer les occurrences de crissement en estimant une approximation de la solution dynamique initiale linéarisée autour d'un point d'équilibre pour une amplitude modale fixée ainsi que la contribution des différents modes potentiellement instables en évaluant la montée en divergence ou l'atténuation des modes potentiellement instables. L'objectif de la MASA est ainsi de fournir une analyse complémentaire à la CEA en identifiant les modes instables du système de frein.

Un exemple d'application de cette méthode MASA aux instabilités de crissement d'un système de frein est décrit dans le document brevet publié sous le numéro FR3039645B1.

Ce document brevet FR3039645B1 divulgue une méthode d'estimation des occurrences de crissement dans des systèmes de frein qui permet d'estimer non seulement la stabilité du point d'équilibre non linéaire mais également l'apparition de fréquences instables causées par la génération du bruit de crissement.

Cette méthode est basée sur un modèle numérique non linéaire du système de frein et permet d'obtenir une approximation de l'évolution dans le temps des parties réelles de valeurs propres complexes quand les amplitudes des vibrations non linéaires initiales augmentent.

Cependant, dans la méthode décrite dans ce document brevet, l'analyse des modes instables est effectuée mode par mode, sur la base des modes identifiés par exemple une méthode telle que la méthode CEA. Une telle approche mono-mode permet d'identifier d'éventuels modes instables que la méthode CEA n'aurait pu identifier. Pour autant, elle ne permet pas de prendre en compte leurs participations.

Cette approche mono-mode ne permet pas non plus de prendre en compte les couplages pouvant apparaitre entre les différentes instabilités et l'impact que ces couplages peuvent avoir sur les participations de chaque mode.

Le brevet FR2988503B1 décrit un procédé de modélisation en vibration d'un système mécanique, tel un système de freinage, en un modèle réduit formé par des super-éléments.

Résumé de l'invention

Selon un premier aspect, l'invention concerne un procédé de prédiction d'instabilités de crissement d'une surface de friction d'un système de frein, le procédé étant mis en oeuvre par ordinateur et comprenant : a) une identification de N modes instables autour d'un point d'équilibre statique, les modes instables étant définis respectivement par N fréquences et N valeurs propres initiales de N modes du système de frein ; b) une modélisation du système de frein par un modèle linéaire dans lequel les efforts non-linéaires sont linéarisés vis-à-vis du déplacement et de la vitesse selon des degrés de liberté du système du frein ; c) une simulation d'une excitation du système de frein en imposant un déplacement selon lesdits degrés de liberté, le déplacement imposé étant sous forme de combinaison linéaire de N déformées modales, une déformée modale correspondant à un mode instable et étant définie par une amplitude modale de niveau variable et une fréquence parmi les N fréquences; d) un calcul d'une évolution d'au moins une valeur propre complexe d'au moins une matrice d'état du modèle linéaire lorsque le niveau d'une amplitude modale d'au moins une déformée modale varie; et e) une identification d'instabilités de crissement du système de frein sur la base de valeurs propres complexes calculées pour les niveaux d'amplitudes modales considérés. Selon l'invention, une valeur courante d'une amplitude modale est définie en fonction du temps par récurrence par rapport à une valeur courante précédente et une amplitude modale initiale, et le procédé comprend un calcul de l'évolution en fonction du temps des valeurs propres complexes pour les niveaux d'amplitudes modales considérés.

La nouvelle méthode proposée ici permet de suivre, au travers de l'évolution en fonction du temps des valeurs propres, l'évolution des modes instables identifiés initialement par exemple une méthode telle que la méthode CEA et de détecter si ces modes sont effectivement instables en régime dynamique. Cette méthode permet également d'identifier, au travers de l'évolution en fonction du temps des valeurs propres, d'éventuels modes instables que la méthode CEA n'aurait pu identifier.

Selon au moins un mode de réalisation du procédé selon le premier aspect, comprenant le calcul de la partie réelle de chaque valeur propre complexe obtenue et de la fréquence correspondante.

Selon au moins un mode de réalisation du procédé selon le premier aspect, dans lequel une valeur courante $p_k(t_{n+1})$ à l'instant $t_{n+1} = t_n + \delta t$ d'une amplitude modale d'un mode k est définie par rapport à la valeur précédente $p_k(t_n)$ à l'instant $t_n$ et à la valeur propre $\lambda_k^n$ obtenue pour le mode k à l'itération précédente de la façon suivante

[Math 101]

$$p_k^{n+1} = p_k^n \exp(\Re(\lambda_k^n)\delta t)$$

Selon au moins un mode de réalisation du procédé selon le premier aspect, dans lequel le système de frein est décomposé en sous-systèmes dynamiques et une matrice d'état du modèle linéaire correspond à une instabilité et un sous-système dynamique du système de frein.

Selon au moins un mode de réalisation du procédé selon le premier aspect, le procédé comprenant en outre : une interruption du calcul de l'évolution des valeurs propres du modèle linéaire sur détermination qu'une nouvelle valeur propre obtenue à l'étape d) ne fait pas partie des N valeurs propres initiales du système de frein et que la partie réelle de la nouvelle valeur propre est positive ; une modification de la modélisation des déplacements de sorte à introduire une fonction de déformation supplémentaire associée à la nouvelle valeur propre et à représenter les déplacements comme combinaison linéaire des N fonctions de déformation et de la fonction de déformation supplémentaire ; une reprise de l'étape d) de calcul de l'évolution des valeurs propres du modèle linéaire sur la base de la modélisation modifiée des déplacements.

Selon un deuxième aspect, l'invention concerne un procédé d'optimisation d'un système de frein, comprenant : une obtention de valeurs de paramètres de conception structurelle du système de frein ; une génération d'un modèle linaire du système de frein à partir des valeurs obtenues ; une identification d'instabilités de crissement du système de frein en mettant en oeuvre un procédé de prédiction d'instabilités de crissement selon l'une quelconque des revendications précédentes sur la base du modèle linéaire généré ; une correction d'au moins une valeur d'au moins un paramètre de conception structurelle du système de frein sur la base des instabilités de crissement identifiées ; une correction du modèle linaire du système de frein à partir de ladite au moins une valeur corrigée ; une identification d'instabilités de crissement du système de frein en mettant en oeuvre un procédé de prédiction d'instabilités de crissement selon l'une quelconque des revendications précédentes sur la base du modèle linéaire corrigé.

Selon un troisième aspect, l'invention concerne un dispositif comprenant des moyens de mise en oeuvre des étapes d'un procédé selon le premier ou deuxième aspect.

Selon un quatrième aspect, l'invention concerne un programme d'ordinateur comportant des instructions de programme pour l'exécution des étapes d'un procédé selon le premier ou deuxième aspect.

Selon un quatrième aspect, l'invention concerne un support d'enregistrement lisible par un ordinateur sur lequel est enregistré un programme d'ordinateur comprenant des instructions de programme pour l'exécution des étapes d'un procédé selon le premier ou deuxième aspect.

Présentation des figures

D'autres avantages et exemples de réalisations sont décrits ci-après par référence aux figures dans lesquelles :

[Fig. 1] représente un exemple de système de frein.

[Fig. 2] est un organigramme d'un procédé de prédiction d'instabilité de crissement pour un système de frein selon la méthode MASA mono-mode ;

[Fig. 3] est un exemple de fonction utilisée dans un procédé de prédiction d'instabilité de crissement pour un système de frein selon un exemple de réalisation ;

[Fig. 4] illustre des aspects mathématiques d'un procédé de prédiction d'instabilité de crissement pour un système de frein selon un exemple de réalisation ;

[Fig. 5] est un organigramme d'un procédé de prédiction d'instabilité de crissement pour un système de frein selon un exemple de réalisation qui applique la méthode MASA multi-mode ;

[Fig. 6A] présente un exemple de courbes d'évolution en fonction de l'amplitude modale de parties réelles des valeurs propres correspondant à différentes modes instables d'un système de frein selon un exemple de réalisation ;

[Fig. 6B] présente des exemples de courbes d'évolution en fonction de l'amplitude modale de fréquences correspondant à différentes modes instables d'un système de frein selon l'exemple de de la Fig. 6A;

[Fig. 7A] présente un exemple de courbes d'évolution temporelle d'amplitude modale, de parties réelles des valeurs propres et fréquences correspondant à différentes modes instables d'un système de frein selon un exemple de réalisation ;

[Fig. 7B] présente un exemple de courbes d'évolution temporelle de parties réelles de valeurs propres selon l'exemple de la Fig. 7A ;

[Fig. 7C] présente un exemple de courbes d'évolution temporelle de parties réelles de fréquences selon l'exemple de la Fig. 7A ;

[Fig. 8A] présente des courbes d'évolution temporelle de parties réelles des valeurs propres correspondant à un premier mode instable d'un système de frein selon un exemple de réalisation ;

[Fig. 8B] présente des courbes d'évolution temporelle de parties réelles des valeurs de fréquences correspondant à un premier mode instable selon l'exemple de la Fig. 8A ;

[Fig. 8C] présente des courbes d'évolution temporelle de parties réelles des valeurs propres correspondant à un deuxième mode instable d'un système de frein selon un exemple de réalisation ;

[Fig. 8D] présente des courbes d'évolution temporelle de parties réelles des valeurs de fréquences correspondant à un deuxième mode instable selon l'exemple de la Fig. 8C .

## Description détaillée

Dans ce document, un modèle en éléments finis d'un système de frein automobile industriel est décrit.

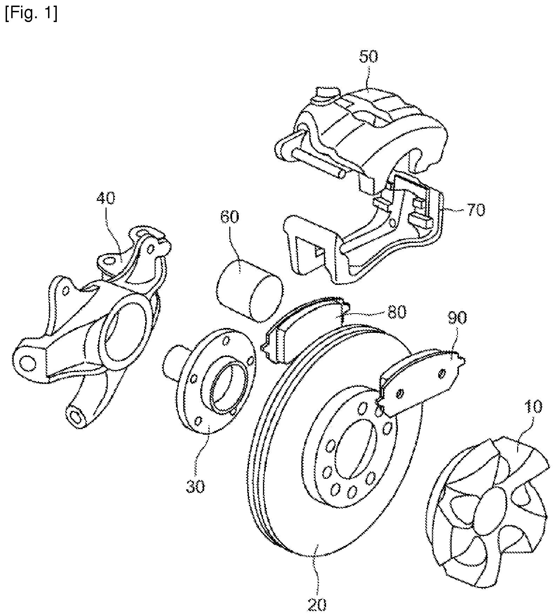

Un exemple de système de frein est présenté en FIG. 1. Ce système de frein est par exemple composé d'une roue 10, d'un disque 20, d'un moyeu 30, d'une articulation 40, d'un étrier 50, d'un piston 60, d'un support 70, d'une plaquette interne 80 et d'une 5 plaquette externe 90. Les tampons 80 et 90 appuient sur le disque 20, en fonction de l'intensité de la commande.

Dans un premier temps, on rappelle ici le formalisme de la méthode MASA dans le cas de l'analyse mono-mode. La méthode MASA mono-mode repose sur une approximation du système non-linéaire par décomposition sur le premier harmonique et une nouvelle linéarisation des forces non linéaires. Les valeurs propres sont obtenues en effectuant une analyse de stabilité par rapport à l'amplitude modale. Une évolution des valeurs propres en fonction de l'amplitude modale est obtenue.

L'équation dynamique du système de frein peut s'écrire sous la forme :

[Math 1]

$$\mathbf{M\ddot{X}} + \mathbf{C\dot{X}} + \mathbf{KX} + \mathbf{F_{p/p}(X)} + \mathbf{F_{e/p}(X)} + \mathbf{F_{c/p}(X)} + \mathbf{F_{nl}(X)} = \mathbf{F_{ext}}$$

dans laquelle **X** est le vecteur des déplacements généralisés et où le point représente la dérivée par rapport au temps. **M, C** et **K** sont respectivement les matrices de masse, d'amortissement et de raideur structurelles du système. **F_{ext}** sont les efforts extérieurs appliqués au système, à savoir la pression appliquée au piston et à l'étrier. Cela correspond à une action par un conducteur du véhicule sur la pédale de frein. **F_{p/p}, F_{e/p}** et **F_{c/p}** sont les contributions apportées par les interfaces des deux sous-systèmes considérés où pour chaque interface le décollement est autorisé. Enfin, **F_{nl}** représente les efforts non-linéaires de contact et de frottement à l'interface de friction, par exemple l'interface entre plaquettes et disque dans le cas d'un frein à disque.

En pratique, le système de frein est chargé de la manière suivante : une force nodale est distribuée uniformément sur la surface de piston et son opposée est distribuée sur l'étrier de la même manière. Comme expliqué précédemment dans l'article Fazio et al, Applied Acoustics, volume 91, 15 avril 2015, pages 12 à 24, les non-linéarités aux interfaces de friction comprennent à la fois les termes non-linéaires cubiques et la potentielle perte de contact entre les surfaces du disque et les surfaces de plaquette. Un champ de vitesse correspondant à la rotation du disque est imposé sur la surface du disque. De cette manière les forces de frictions sont déduites des forces de contact normales en utilisant la loi de Coulomb classique. Un état de glissement permanent est envisagé et on fait l'hypothèse d'un coefficient de friction constant.

## Analyse de stabilité

L'analyse de stabilité peut être effectuée de la manière suivante. Une position d'équilibre statique **U_S** est déterminée en résolvant l'équation :

[Math 2]

$$\mathbf{KU_S} + \mathbf{F_{p/p}(U_S)} + \mathbf{F_{e/p}(U_S)} + \mathbf{F_{c/p}(U_S)} + \mathbf{F_{nl}(U_S)} = \mathbf{F_{ext}}$$

On définit une matrice **K_{nl,Us}** comme suit :

[Math 3]

$$\mathbf{K_{nl,U_S}} = \mathbf{J_{p/p}} + \mathbf{J_{e/p}} + \mathbf{J_{c/p}}$$

où les $\mathbf{J_k}$ sont les matrices Jacobiennes des efforts $\mathbf{F_k}$ au point d'équilibre statique $\mathbf{U_S}$. où $k$ identifie l'une des interfaces parmi les interfaces désignées par p/p, e/p et c/p, avec p/p = piston/plaquette, e/p = étrier/plaquette et c/p = chape/plaquette.

Ainsi, en considérant une légère perturbation ∆U autour du point d'équilibre statique $\mathbf{U_S}$, l'équation Math 1 devient :

[Math 4]

$$\mathbf{M\Delta\ddot{U}} + \mathbf{C\Delta\dot{U}} + (\mathbf{K} + \mathbf{K_{nl,U_S}})\mathbf{\Delta U} + \mathbf{F_{nl}(U_S + \Delta U)} - \mathbf{F_{nl}(U_S)} = \mathbf{0}$$

Le développement de Taylor au premier ordre des efforts non-linéaires autour de la position d'équilibre donne :

[Math 5]

$$\mathbf{F_{nl}(U_S + \Delta U)} = \mathbf{F_{nl}(U_S)} + \mathbf{J_{nl}\Delta U} + \mathscr{O}(\mathbf{\Delta U}^2)$$

et le problème aux valeurs propres associé est :

[Math 6]

$$\left(\lambda^2\mathbf{M} + \lambda\mathbf{C} + \left(\mathbf{K} + \mathbf{K_{nl,U_S}} + \mathbf{J_{nl}}\right)\right)\mathbf{\Psi} = \mathbf{0}$$

Ces développements correspondent à la méthode CEA classique et permettent de déterminer les valeurs propres complexes $\lambda j$ et leur mode propre associé $\Psi j$. La stabilité du système est déduite en fonction de la partie réelle des valeurs propres $\lambda j$.

**Nouvelle linéarisation du problème**

A partir de l'équation Math 5, on pose $\Omega$ tel que :

[Math 7]

$$\mathbf{F_{nl}(U_S + \Delta U)} = \mathbf{F_{nl}(U_S)} + \mathbf{J_{nl}\Delta U} + \mathbf{\Omega}$$

où $\Omega$ représente l'erreur commise sur le développement de Taylor à l'ordre 1. Ainsi, l'équation Math 4 peut se réécrire :

[Math 8]

$$\mathbf{M\Delta\ddot{U}} + \mathbf{C\Delta\dot{U}} + (\mathbf{K} + \mathbf{K_{nl,U_S}} + \mathbf{J_{nl}})\mathbf{\Delta U} + \mathbf{\Omega} = \mathbf{0}$$

Lorsque $\Omega = 0$, le problème aux valeurs propres associé à l'équation Math 8 correspond à l'équation Math 6 et permet d'assurer la continuité de la méthode.

La solution recherchée du problème est une solution périodique, elle peut donc être approximée par une série de Fourier tronquée à l'ordre $N_h$. En d'autres termes, la perturbation ∆U peut s'écrire :

[Math 9]

$$\mathbf{\Delta U}(t) = \sum_{k=0}^{N_h} \mathbf{\Delta U}_k(t) = \sum_{k=0}^{N_h} \mathbf{\Delta U}_k^C \cos(k\omega t) + \sum_{k=1}^{N_h} \mathbf{\Delta U}_k^S \sin(k\omega t)$$

où $\Delta\mathbf{U}_k(t)$ est la $k^{\text{ième}}$ harmonique de $\Delta\mathbf{U}(t)$ dans le domaine temporel et de coefficients de Fourier associés $\Delta\mathbf{U}c$ et $\Delta\mathbf{U}s$. $\omega$ correspond à la pulsation des cycles limites non-linéaires.

De la même manière, les efforts non-linéaires $\Omega$ peuvent être décomposés sous la forme d'une série de Fourier tronquée :

[Math 10]

$$\mathbf{\Omega} = \sum_{k=0}^{N_h} \mathbf{\Omega}_k^C \cos(k\omega t) + \sum_{k=1}^{N_h} \mathbf{\Omega}_k^S \sin(k\omega t)$$

L'expression des efforts non-linéaires $\mathbf{F_{nl}}$ en fonction du temps est connue de façon analytique. Ainsi, les efforts $\Omega(t)$ peuvent être exprimés dans le domaine temporel et l'utilisation d'un algorithme tel que l'algorithme AFT [Alternate Frequency Time], alternant les domaines fréquentiel et temporel, permet de déterminer les coefficients de Fourier $\mathbf{\Omega}_k^C$ et $\mathbf{\Omega}_k^S$.

L' algorithme AFT est décrit par exemple dans le document CAMERON, T. M. et GRIFFIN, J. H. An alternating frequency/time domain method for calculating the steady-state response of nonlinear dynamic systems. Journal of applied mechanics, 1989, vol. 56, no 1, p. 149-154

La méthode part du postulat que le caractère stable ou instable d'un mode est lié à sa première harmonique et que donc l'étude de la seule stabilité d'un système peut se faire en se limitant à une unique harmonique. L'injection des équations Math 9 et Math 10 dans l'équation Math 8 et la troncature à la première harmonique donne le système dynamique suivant :

[Math 11]

$$\mathbf{M\Delta\ddot{U}_1 + C\Delta\dot{U}_1 + (K + K_{nl,U_S} + J_{nl})\Delta U_1 + \Omega_1 = 0}$$

où :

[Math 12]

$$\mathbf{\Delta U}_1 = \mathbf{\Delta U}_1^C \cos(\omega t) + \mathbf{\Delta U}_1^S \sin(\omega t)$$

et

[Math 13]

$$\mathbf{\Omega}_1 = \mathbf{\Omega}_1^C \cos(\omega t) + \mathbf{\Omega}_1^S \sin(\omega t)$$

L'originalité de la méthode réside dans la linéarisation de $\Omega$ sous la forme :

[Math 14]

$$\boldsymbol{\Omega}_1 = \mathbf{K}_1 \boldsymbol{\Delta}\mathbf{U} + \mathbf{C}_1 \boldsymbol{\Delta}\dot{\mathbf{U}}$$

Cette linéarisation composée d'un terme de raideur équivalente et d'amortissement équivalent permet de considérer le déphasage entre les composantes de chargement de $\Omega_1$ et les déplacements $\Delta\mathbf{U}_1$. De plus, les matrices $\mathbf{K}_1$ et $\mathbf{C}_1$ peuvent être déterminées analytiquement. La formulation analytique est donnée ultérieurement.

**Stabilité du nouveau système**

En injectant l'équation Math 14 dans l'équation Math 11, il vient :

[Math 15]

$$\mathbf{M}\Delta\ddot{\mathbf{U}}_1 + (\mathbf{C} + \mathbf{C}_1)\Delta\dot{\mathbf{U}}_1 + \left(\mathbf{K} + \mathbf{K}_{\mathbf{nl},\mathbf{U}_S} + \mathbf{J}_{\mathbf{nl}} + \mathbf{K}_1\right)\Delta\mathbf{U}_1 = 0$$

qui peut être réécrit en utilisant la variable d'état Y

[Math 16]

$$\mathbf{Y} = \left(\boldsymbol{\Delta}\mathbf{U}_1 \ \boldsymbol{\Delta}\dot{\mathbf{U}}_1\right)^{\mathrm{T}}$$

sous la forme :

[Math 17]

$$\dot{\mathbf{Y}}_1 = \mathbf{A}\mathbf{Y}_1$$

avec la matrice dynamique A :

[Math 18]

$$\mathbf{A} = \begin{bmatrix} \mathbf{0} & \mathbf{I} \\ -\mathbf{M}^{-1}\left(\mathbf{K} + \mathbf{K}_{\mathbf{nl},\mathbf{U}_S} + \mathbf{J}_{\mathbf{nl}} + \mathbf{K}_1\right) & -\mathbf{M}^{-1}(\mathbf{C} + \mathbf{C}_1) \end{bmatrix}$$

Conformément à la théorie de la stabilité des systèmes dynamiques, la stabilité du système selon l'équation Math 16 est déterminée en calculant les valeurs propres de la matrice A. Ainsi, la partie réelle associée à la valeur propre du mode instable $j$ permet de statuer sur la divergence du mode $j$, un mode instable correspondant à une partie réelle positive. En outre, la partie imaginaire associée correspond à la pulsation du mode $j$ qui participe à la dynamique de la solution linéarisée autour du point d'équilibre pour une amplitude modale initiale fixée. Si d'autres valeurs propres ont une partie réelle qui devient positive, alors il y a un potentiel risque de divergence des modes correspondants. Aussi il est pertinent d'utiliser dans ces conditions une MASA avec une approche multi-fréquentielle afin de prendre en considération ces modes dans la solution approchée et de statuer sur leur divergence. Cette méthode MASA multi-fréquentielle (appelée aussi multi-mode) sera décrite plus en détail ci-dessous.

**Expression des déplacements**

Les déplacements $\Delta\mathbf{U}$ correspondent aux déplacements des degrés de liberté du système de frein.

Le principe de la méthode MASA consiste à étudier la stabilité du système pour des niveaux de vibration donnés. C'est-à-dire que les déplacements $\Delta\mathbf{U}$ sont fixés (i.e. imposés par la simulation ) et que les efforts non linéaires $\Omega$, et donc la matrice d'état dynamique $\mathbf{A}$, sont déterminés en fonction des déplacements $\Delta\mathbf{U}$ **imposés**. La linéarisation et l'analyse de stabilité faite sur la matrice d'état dynamique $\mathbf{A}$ sont valables uniquement pour les niveaux de vibration considérés. L'écriture des déplacements $\Delta U$ est expliquée ci-après.

Supposons que le $j^{ième}$ mode soit instable et de valeur propre $\lambda_j = a_j + i\omega_j$ alors l'écriture Math 12 est équivalente à l'écriture suivante :

[Math 19]

$$\begin{cases} \Delta \mathbf{U}_1 = \mathbf{X}_1 e^{\lambda_j t} + \overline{\mathbf{X}_1} e^{\overline{\lambda_j} t} \\ \Re(\lambda_j) = 0 \end{cases}$$

où

[Math 20]

$$\mathbf{X}_1 = \tfrac{1}{2}(\Delta \mathbf{U}_1^C - i\Delta \mathbf{U}_1^S) \text{ et } \omega = \omega_j$$

où $X_1$ représente la déformée modale non normalisée.

On notera au passage que l'écriture de la solution à la première harmonique introduit naturellement la condition de stabilité donnée par

[Math 21]

$$\Re(\lambda_j) = 0$$

Si les déplacements $\Delta U$ sont non nuls et connus, alors $\lambda_j$ est déduit de la matrice $A$ en résolvant :

[Math 22]

$$\lambda_j = \mathbf{\Psi}_j^T \mathbf{A} \mathbf{\Psi}_j$$

avec :

[Math 23]

$$\mathbf{\Psi}_j = \frac{1}{\eta} \begin{pmatrix} \mathbf{X}_1 \\ i\omega_j \mathbf{X}_1 \end{pmatrix}$$

Où

[Math 24]

$$\eta = \left\| \begin{matrix} \mathbf{X}_1 \\ i\omega_j \mathbf{X}_1 \end{matrix} \right\|$$

La réponse périodique d'un tel système est principalement pilotée par le mode instable identifié linéarisé autour de la position d'équilibre, c'est-à-dire que l'on peut approximer $\Delta U(t)$ par

[Math 25]

$$c\left(\mathbf{\Psi}_j e^{i\omega_j t} + \overline{\mathbf{\Psi}_j} e^{-i\omega_j t}\right)$$

où $c$ est un coefficient réel et $\Psi_j$ la déformée (appelée aussi déformée modale) du mode instable j. L'idée ici consiste à considérer différents niveaux d'amplitude de ce mode et pour chacun de ces niveaux d'amplitude à statuer sur la stabilité de la solution linéarisée pour le niveau d'amplitude considéré.

Ainsi, si un mode instable $j$ de mode propre $\mathbf{\Psi}_j^0$ a été identifié au cours de la CEA avec une valeur propre associée

[Math 26]

$$\lambda_j = a_j + i\omega_j^0$$

où $a_j$ est la partie réelle supposée positive ici et $\omega_j^0$ sa pulsation, alors on considère différents niveaux d'amplitude modale $p_j^m$, où $m$ fait référence à l'indice de balayage.

On fait l'hypothèse que les niveaux d'amplitude restent faibles et que l'on cherche principalement à étudier l'influence des micro-impacts sur la stabilité. Alors, on peut supposer que la déformée du mode ainsi que sa pulsation évoluent peu. En d'autres termes, la déformée $\mathbf{\Psi}_j^0$ et la pulsation $\omega_j^0$ n'évoluent pas avec $p_j^m$. Ainsi, $\mathbf{X}_l^m$ se déduit de :

[Math 27]

$$\begin{pmatrix} \mathbf{X}_1^m \\ i\omega_j^0 \mathbf{X}_1^m \end{pmatrix} = p_j^m \mathbf{\Psi}_j^0$$

La déformée $\mathbf{\Psi}_j^0$ restant constante, $\lambda_j^m$ est déduite à partir du calcul des valeurs propres de la matrice $\mathbf{A}^m$ qui représente la matrice dynamique de l'instabilité au pas d'itération $m$.

Expression des matrices K1 et C1

Les matrices $\mathbf{K}_1$ et $\mathbf{C}_1$ qui représentent respectivement les matrices de raideur et d'amortissement équivalentes sont définies à partir de l'équation Math 14 et peuvent être déterminées analytiquement. En effet, pour chaque élément de contact $n$, le déplacement relatif normal $\delta^n$ peut s'écrire :

[Math 28]

$$\delta^n(t) = \delta_c \cos(\omega t) + \delta_s \sin(\omega t)$$

Par ailleurs, les efforts dans la direction $d$, qui peut être tangentielle ou normale, entre deux noeuds en contact sont :

[Math 29]

$$\boldsymbol{\Omega}_1^{n,d}(t) = \tau_c \cos(\omega t) + \tau_s \sin(\omega t)$$

Ainsi, pour chaque direction *d,* ces efforts doivent vérifier l'équation :

[Math 30]

$$\boldsymbol{\Omega}_1^{n,d}(t) = \mathbf{k}^{n,d}\delta^n(t) + \mathbf{c}^{n,d}\dot{\delta}^n(t)$$

La résolution des équations donne :

[Math 31]

$$\begin{cases} \mathbf{k}^{n,d} = \frac{\delta_c\tau_c + \delta_s\tau_s}{\delta_c^2 + \delta_s^2} & \mathbf{c}^{n,d} = \frac{\delta_s\tau_c - \delta_c\tau_s}{\omega(\delta_c^2 + \delta_s^2)} & \text{si } \delta_c \neq 0 \text{ ou } \delta_s \neq 0 \\ \mathbf{k}^{n,d} = 0 & \mathbf{c}^{n,d} = 0 & \text{sinon} \end{cases}$$

Synthèse

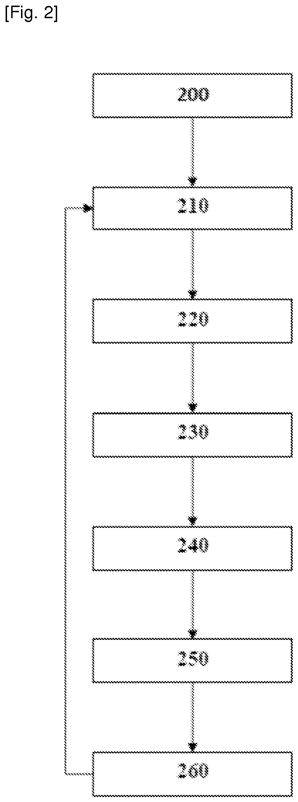

En résumé, la démarche générale de la méthode MASA mono-mode peut être synthétisée en référence à la figure 2 de la façon suivante.

Etape 200 d'initialisation : on met en oeuvre une détermination de valeurs propres du système de frein par exemple par une méthode CEA classique sur le système initial. Chaque mode instable *j* est identifié ainsi que sa déformée $\Psi_j^0$ et sa pulsation associée $\omega_j^0$. Cette étape correspond à un facteur d'amplitude modale $p_j^0 = 0.$

Les étapes 210 à 260 sont ensuite mises en oeuvre pour chaque mode instable j identifié. L'indice correspondant à l'itération courante est m.

Etape 210 : on fixe une valeur de l'amplitude modale $p_j^m$. On effectue un balayage en amplitude modale, c'est-à-dire qu'on considère un vecteur $p = [p^1, p^2, \dots, p^m, \dots, p^{end})]$, on prend la p-ième valeur du vecteur . Les plages de variations sont à déterminer par l'utilisateur . A partir de l'amplitude modale $p_j^m$, représentant la déformée modale non normalisée $X_1^m$ est déterminée à partir de l'équation Math 27.

Etape 220 : les coefficients de Fourier des déplacements $\Delta\mathbf{U}_1^{C,m}$ et $\Delta\mathbf{U}_1^{S,m}$ sont calculés à partir de l'équation Math 19.

Etape 230 : le déplacement $\Delta\mathbf{U}_1^m(t, \omega_j^0)$ est déterminé en appliquant la transformée de Fourier inverse.

Etape 240 : les efforts non-linéaires $\Omega_1^m(\Delta\mathbf{U}_1^m(t, \omega_j^0))$ sont calculés à partir de l'équation Math 7 et exprimés dans l'espace de Fourier.

Etape 250 : les matrices $\mathbf{K}_1$ et $\mathbf{C}_1$ représentant respectivement les matrices de raideur et d'amortissement équivalent de $\Omega$ sont déterminées à partir de l'équation Math 31.

Etape 260 : la matrice d'état A^m pour l'itération m est déterminée et les valeurs propres de cette matrice d'état A^m sont déterminées.

Les étapes 220 à 260 sont répétées pour toutes les valeurs d'amplitude modale $p_j^m$ considérées.

Cas multi-mode (ou multi-fréquence)

Le formalisme de la méthode MASA dans le cas multi-fréquentiel (i.e. multi-mode) va maintenant être présenté.

Dans de nombreux systèmes auto-entretenus, plusieurs instabilités sont identifiées lors d'un calcul par la méthode CEA et les réponses des systèmes dynamiques peuvent être quasi-périodiques. Il est alors nécessaire de développer des méthodes permettant de traiter le cas multi- instable. Cette partie propose une adaptation de la méthode présentée précédemment au cas où $N_i$ instabilités sont identifiées par la méthode CEA.

Écriture des déplacements dans le cas multi-fréquentiel

La solution recherchée ici est supposée quasi-périodique, c'est-à-dire qu'elle est caractérisée par $N_i$ fréquences $f_i$ d'excitations incommensurables, c'est-à-dire que les $N_i$ fréquences sont telles que

[Math 32]

$$\forall i \neq j, (i,j) \in [1, N_i]^2, f_i / f_j \notin \mathbb{N}$$

Dans le cas des systèmes non-linéaires, le contenu fréquentiel des oscillations s'écrit comme une combinaison linéaire de toutes les fréquences fondamentales incommensurables. Ainsi, si $N_h$ harmoniques de la solution sont retenues, alors les différentes fréquences observables sont de la forme :

[Math 33]

$$k_1 \omega_1 + \ldots + k_j \omega_j + \ldots + k_{N_i} \omega_{N_i}$$

où

[Math 34]

$$k_j \in [-N_h, +N_h] \text{ et } j \in [1, N_i]$$

Ainsi, la réponse du système peut être décomposée comme dans le cas mono-fréquentiel en une série de Fourier généralisée, c'est-à-dire que le déplacement $\Delta U$ peut s'écrire :

[Math 35]

$$\Delta \mathbf{U}(t) = \sum_{k_1=-N_h}^{N_h} \ldots \sum_{k_{N_i}=-N_h}^{N_h} \left( \Delta \mathbf{U}_{k_1 \ldots k_{N_i}}^C \cos((k_1\omega_1 + \ldots + k_{N_i}\omega_{N_i})t) + \Delta \mathbf{U}_{k_1 \ldots k_{N_i}}^S \sin((k_1\omega_1 + \ldots + k_{N_i}\omega_{N_i})t) \right)$$

où les coefficients $\Delta \mathbf{U}_{k_1 \ldots k_{N_i}}^C$ et $\Delta \mathbf{U}_{k_1 \ldots k_{N_i}}^S$ correspondent aux coefficients de Fourier associés à toutes les combinaisons linéaires possibles des composantes fréquentielles $\omega 1$, $\omega 2$, ..., $\omega_{N_i}$. Une écriture plus condensée consisterait à introduire la base

[Math 36]

$$\boldsymbol{\omega} = \begin{bmatrix} \omega_1 & \omega_2 & \ldots & \omega_{N_i} \end{bmatrix}$$

et à poser :

[Math 37]

$$\boldsymbol{\tau} = \boldsymbol{\omega}\, t$$

Où

[Math 38]

$$\boldsymbol{\tau} = \begin{bmatrix} \tau_1 & \tau_2 & \ldots & \tau_{N_i} \end{bmatrix}$$

est appelée variable d'hyper-temps. Cette variable d'hyper-temps est $2\pi$ périodique sur chaque dimension $\tau_j$. On peut alors définir

[Math 39]

$$\mathbf{k} = \begin{bmatrix} k_1 & k_2 & \ldots & k_{N_i} \end{bmatrix}$$

le vecteur du nombre d'harmoniques dans chaque dimension $\tau_j$. Avec ces notations, l'équation Math 35 peut s'écrire sous la forme :

[Math 40]

$$\Delta\mathbf{U}(\boldsymbol{\tau}) = \Delta\mathbf{U}_0 + \sum_{\mathbf{k}\in\mathbb{Z}^{N_i}} \Delta\mathbf{U}_{\mathbf{k}}^{C}\cos(\mathbf{k}.\boldsymbol{\tau}) + \sum_{\mathbf{k}\in\mathbb{Z}^{N_i}} \Delta\mathbf{U}_{\mathbf{k}}^{S}\sin(\mathbf{k}.\boldsymbol{\tau})$$

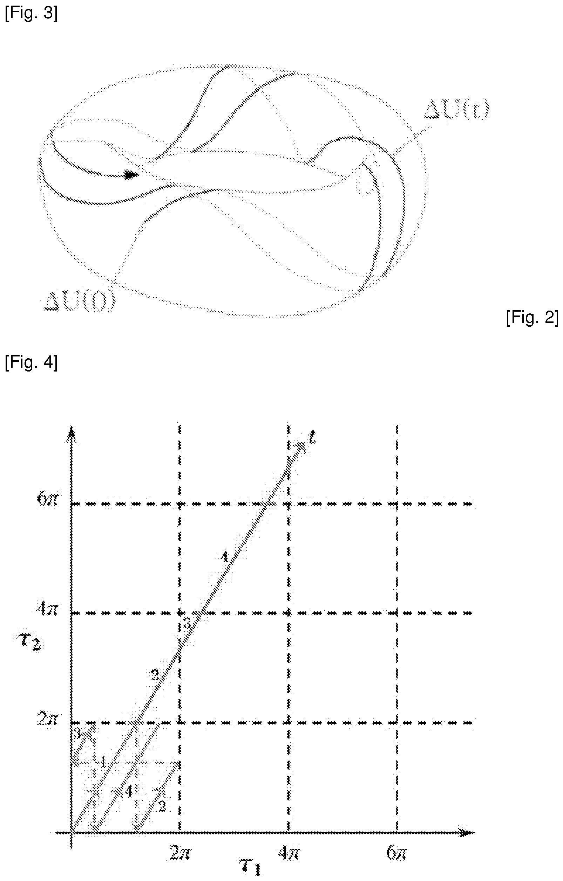

Il est à noter que cette transformation permet de passer d'un domaine temporel $t \in \mathbb{R}_+$ à un domaine temporel multi-périodique $\tau \in \mathbb{R}_+^{N_i}$ où chaque dimension $\tau_j$ est caractérisée par une fréquence fondamentale $f_j$ du système dynamique. Ainsi, l'équation Math 40 est $2\pi$ périodique dans chaque dimension et $\Delta U(\tau)$ est une fonction de temps multi-dimensionnelle qui décrit l'évolution temporelle de la fonction multi-fréquentielle $\Delta U(t)$. Cette fonction est souvent appelée fonction tore. Par exemple, dans le cas de la dimension 2, la fonction $\Delta U(t)$ est bi-périodique et évolue dans $\mathbb{R}^3$ sur un tore formé par les deux paramètres d'hyper-temps ($\tau 1$, $\tau 2$). Un exemple est donné en FIG. 3.

L'espace de temps physique est remplacé par un espace multi-dimensionnel dont la paramétrisation suivante permet de trouver $\tau$ correspondant à un instant t :

[Math 41]

$$\begin{cases} \tau_1 \equiv \omega_1\, t\,[2\pi] \\ \vdots \\ \tau_{N_i} \equiv \omega_{N_i}\, t\,[2\pi] \end{cases}$$

De ce fait, il existe une bijection entre le temps t et les paramètres $\tau_j$. Dans le cas de la dimension 2, l'illustration du passage du domaine temporel au domaine hyper-temps est représenté en FIG. 4. Ainsi, pour tout instant t, il est possible d'associer un unique point dans l'ensemble

[Math 42]

$$[\tau_1 \; \ldots \; \tau_{N_i}] \in [0, 2\pi]^{N_i}$$

Il n'existe à ce jour aucune méthode d'approximation permettant de faire le passage inverse, c'est-à-dire trouver l'instant t correspondant à un point de l'ensemble défini à l'équation Math 41. La conservation de l'orthogonalité de la série de Fourier permet cependant d'utiliser une transformée de Fourier multi-dimensionnelle dans une procédure AFT.

Ainsi les différentes équations écrites dans le domaine de Fourier mono-fréquentiel restent valables dans le domaine multi-fréquentiel et les déplacements ΔU et les efforts non-linéaires Ω peuvent alors s'écrire sous la forme :

[Math 43]

$$\Delta\mathbf{U}(\boldsymbol{\tau}) = \Delta\mathbf{U}_0 + \sum_{\mathbf{k}\in\mathbb{Z}^{N_i}} \Delta\mathbf{U}_{\mathbf{k}}^{C}\cos(\mathbf{k}.\boldsymbol{\tau}) + \sum_{\mathbf{k}\in\mathbb{Z}^{N_i}} \Delta\mathbf{U}_{\mathbf{k}}^{S}\sin(\mathbf{k}.\boldsymbol{\tau})$$

et

[Math 44]

$$\boldsymbol{\Omega}(\boldsymbol{\tau}) = \boldsymbol{\Omega}_0 + \sum_{\mathbf{k}\in\mathbb{Z}^{N_i}} \boldsymbol{\Omega}_{\mathbf{k}}^{C}\cos(\mathbf{k}.\boldsymbol{\tau}) + \sum_{\mathbf{k}\in\mathbb{Z}^{N_i}} \boldsymbol{\Omega}_{\mathbf{k}}^{S}\sin(\mathbf{k}.\boldsymbol{\tau})$$

Comme précédemment, seuls les termes de première harmonique sont retenus. C'est-à-dire que :

[Math 45]

$$\Delta\mathbf{U}_1 = \sum_{k=1}^{N_i} \Delta\mathbf{U}_{\mathbf{v}_k} = \sum_{k=1}^{N_i} \Delta\mathbf{U}_{\mathbf{v}_k}^{C}\cos(\omega_k t) + \sum_{k=1}^{N_i} \Delta\mathbf{U}_{\mathbf{v}_k}^{S}\sin(\omega_k t)$$

[Math 46]

$$\boldsymbol{\Omega}_1 = \sum_{k=1}^{N_i} \boldsymbol{\Omega}_{\mathbf{v}_k} = \sum_{k=1}^{N_i} \boldsymbol{\Omega}_{\mathbf{v}_k}^{C}\cos(\omega_k t) + \sum_{k=1}^{N_i} \boldsymbol{\Omega}_{\mathbf{v}_k}^{S}\sin(\omega_k t)$$

où $v_k$ est un vecteur nul de taille $N_i$ dont seule la $k^{\text{ième}}$ composante est égale 1.

Linéarisation

L'équation du mouvement Math 8 projetée sur les termes de première harmonique s'écrit alors :

[Math 47]

$$\mathbf{M}\sum_{k=1}^{N_i} \Delta\ddot{\mathbf{U}}_{\mathbf{v}_k} + \mathbf{C}\sum_{k=1}^{N_i} \Delta\dot{\mathbf{U}}_{\mathbf{v}_k} + \left(\mathbf{K} + \mathbf{K}_{\mathbf{nl},\mathbf{U}_S} + \mathbf{J}_{\mathbf{nl}}\right)\sum_{k=1}^{N_i} \Delta\mathbf{U}_{\mathbf{v}_k} + \sum_{k=1}^{N_i} \boldsymbol{\Omega}_{\mathbf{v}_k} = 0$$

L'orthogonalité de la série de Fourier permet d'écrire les $N_i$ équations suivantes :

[Math 48]

$$\forall k \in [1, N_i], \; \mathbf{M}\Delta\ddot{\mathbf{U}}_{v_k} + \mathbf{C}\Delta\dot{\mathbf{U}}_{v_k} + \left(\mathbf{K} + \mathbf{K}_{nl,U_S} + \mathbf{J}_{nl}\right)\Delta\mathbf{U}_{v_k} + \mathbf{\Omega}_{v_k} = \mathbf{0}$$

et sur chaque harmonique, $\Omega_{vk}$ est linéarisé de la façon suivante :

[Math 49]

$$\mathbf{\Omega}_{v_k} = \mathbf{K}_{v_k}\Delta\mathbf{U}_{v_k} + \mathbf{C}_{v_k}\Delta\dot{\mathbf{U}}_{v_k}$$

Ainsi, on aboutit à $N_i$ sous-systèmes $Y_k$ de la forme :

[Math 50]

$$\forall k \in [1, N_i], \; \dot{\mathbf{Y}}_k = \mathbf{A}_k\mathbf{Y}_k$$

où T

[Math 51]

$$\mathbf{Y}_k = \left(\Delta\mathbf{U}_{v_k} \;\; \Delta\dot{\mathbf{U}}_{v_k}\right)^{\mathrm{T}}$$

et les matrices d'état dynamiques $A_k$ sont définies de la façon suivante :

[Math 52]

$$\mathbf{A}_k = \begin{bmatrix} \mathbf{0} & \mathbf{I} \\ -\mathbf{M}^{-1}\left(\mathbf{K} + \mathbf{K}_{nl,U_S} + \mathbf{J}_{nl} + \mathbf{K}_{v_k}\right) & -\mathbf{M}^{-1}\left(\mathbf{C} + \mathbf{C}_{v_k}\right) \end{bmatrix}$$

Ainsi, à chaque instabilité k est associé un sous-système dynamique sur lequel il est possible de réaliser une analyse de la divergence ou de l'atténuation de la solution dynamique linéarisée autour d'un point d'équilibre pour un jeu d'amplitude modale choisie. L'analyse de la divergence de chaque mode instable k se fait à partir de la partie réelle de la valeur propre associée au mode k dans le sous-système *k*. En effet, chaque $\mathbf{Y_k}$ est lié uniquement à $\omega_k$ et il n'y a donc pas de contribution modale des modes *j* avec $j \neq k$ dans $\mathbf{Y_k}$. De plus, la projection sur la première harmonique ne fait pas apparaitre de terme en $\mathbf{A_j} * \mathbf{Y_k}$.

Dans le cas où un sous-système *k* ferait émerger une instabilité sur le mode *j,* pour savoir si la divergence associée au mode *j* se traduit effectivement par une divergence dans l'équation Math 47 du mouvement, il est nécessaire de considérer le sous-système *j* qui est le seul à donner la contribution du mode *j* dans l'équation du mouvement. Dans le cas où le mode *j* est identifié stable par la méthode CEA, il est possible de l'ajouter à la base utilisée pour MASA.

Calcul des amplitudes modales

Comme précédemment, on peut écrire $\Delta\mathbf{U_1}$ sous la forme :

[Math 53]

$$\begin{cases} \Delta \mathbf{U_1} = \sum_{k=1}^{N_i} \left( \mathbf{X}_k e^{\lambda_k t} + \overline{\mathbf{X}_k} e^{\overline{\lambda_k} t} \right) \\ \forall k \in [1, N_i], \ \Re(\lambda_k) = 0 \end{cases}$$

où chaque

[Math 54]

$$\mathbf{X}_k = \frac{1}{2} \left( \Delta \mathbf{U_{v_k}^C} - i \Delta \mathbf{U_{v_k}^S} \right).$$

représente une déformée modale non normalisée.

Si les déplacements $\Delta \mathbf{U_1}$ sont non nuls et connus, alors chaque valeur propre $\lambda_j$ est déduite de la matrice $\mathbf{A_j}$ associée au sous-système $j$ correspondant de la façon suivante :

[Math 55]

$$\lambda_j = \mathbf{\Psi}_j^{\mathrm{T}} \mathbf{A}_j \mathbf{\Psi}_j$$

La réponse quasi-périodique d'un tel système est pilotée principalement par les modes instables identifiés linéarisés autour de la position d'équilibre, c'est-à-dire que l'on peut approcher les déplacements par :

[Math 56]

$$\Delta \mathbf{U}(t) \approx \sum_{k=1}^{N_i} c_k \left( \mathbf{\Psi}_k e^{i\omega_k t} + \overline{\mathbf{\Psi}_k} e^{-i\omega_k t} \right)$$

où les $c_k$ sont des coefficients réels.

De la même manière que précédemment, si $N_i$ modes instables de modes propres, correspondant aux déformées :

[Math 57]

$$\left( \mathbf{\Psi}_k^0 \right)_{k \in [1, N_i]}$$

sont identifiés par la méthode CEA avec une valeur propre associée :

[Math 58]

$$\lambda_k^0 = a_j^0 + i\omega_k^0$$

alors on considère les différents vecteurs d'amplitude modale

[Math 59]

$$\mathbf{p}^m = [p_1^m \ \dots \ p_k^m \ \dots \ p_{N_i}^m]$$

où chaque $p_k^m$ correspond à l'amplitude modale associée au mode $k$ pour le pas de balayage numéro $m$. On suppose ici aussi que les niveaux d'amplitude restent suffisamment faibles afin que les déformées $\Psi_k^0$ et les pulsations $\omega_k^0$ n n'évoluent pas avec $p^m$. Ainsi, pour chaque mode k on a :

[Math 60]

$$\begin{pmatrix} \mathbf{X}_k^m \\ i\omega_k \mathbf{X}_k^m \end{pmatrix} = p_k^m \mathbf{\Psi}_k^0$$

Puis chaque valeur propre $\lambda_k$ est obtenue en déterminant les valeurs propres de la matrice $A_k$.

Il est envisageable dans un premier temps de considérer une grille pour pouvoir effectuer le balayage sur **p** mais cette approche serait coûteuse numériquement. Pour cette raison, une approche plus restrictive, mais qui propose une vision "physique" du développement des réponses vibratoires est considérée et consiste à revenir dans le temporel afin d'établir un lien entre les différentes amplitudes modales.

Ainsi, si chaque mode est caractérisé par une amplitude modale

[Math 61]

$$p_k(t_n)$$

en un instant $t_n$ et une valeur propre $\lambda_k^n$, alors l'amplitude $p_k(t_{n+1})$ à l'instant $t_{n+1} = t_n + \delta t$ sera liée à $p_k(t_{n+1})$ et à $\lambda_k^n$ de la façon suivante :

[Math 62]

$$p_k^{n+1} = p_k^n \exp(\Re(\lambda_k^n)\delta t)$$

Où

[Math 63]

$$\Re$$

correspond à la fonction partie réelle, cette fonction étant appliquée ici à la valeur propre

$$\lambda_k^n.$$

Cette équation est équivalente à :

[Math 64]

$$\forall (i,j) \in [1, N_i]^2, \left(\frac{p_j^{n+1}}{p_j^n}\right)^{1/\Re(\lambda_j^n)} = \left(\frac{p_i^{n+1}}{p_i^n}\right)^{1/\Re(\lambda_i^n)}$$

Ainsi, les différentes amplitudes modales sont liées les unes aux autres et avec cette approche le balayage ne se fait plus en amplitude modale mais en temps. Le choix du pas de temps est fait de sorte que l'équation Math 62 reste valable, c'est-à-dire que considérer un accroissement constant et égal à :

[Math 65]

$$\Re(\lambda_k^n)$$

entre les instants $t_n$ et $t_{n+1}$ est une approximation valide. Il est à noter que chaque valeur propre $\lambda_k^n$ est déterminée à partir de la matrice $\mathbf{A}_k^n$ associée au sous-système du mode $k$ à l'instant $t_n$.

Calcul des efforts non-linéaires $\Omega_{vk}$

Les efforts non-linéaires $\Omega$ sont définis comme précédemment par :

[Math 66]

$$\mathbf{\Omega} = \mathbf{F_{nl}}(\mathbf{U_S} + \mathbf{\Delta U}) - \mathbf{F_{nl}}(\mathbf{U_S}) - \mathbf{J_{nl}}\mathbf{\Delta U}$$

L'utilisation d'un algorithme AFT permet de les calculer directement à partir de l'expression de $\Delta \mathbf{U}(t)$. Ils sont ensuite projetés sur chaque harmonique et les coefficients de Fourier sont déterminés.
Il est important de remarquer que le couplage entre les différents modes se fait à travers ces efforts non-linéaires. En effet, en considérant une troncature à l'harmonique 1, l'équation Math 66 devient :

[Math 67]

$$\mathbf{\Omega_1} = \sum_{k=1}^{N_i} \mathbf{\Omega_{v_k}} = \mathbf{F_{nl}}\left(\mathbf{U_S} + \sum_{k=1}^{N_i} \mathbf{\Delta U_{v_k}}\right) - \mathbf{F_{nl}}(\mathbf{U_S}) - \mathbf{J_{nl}} \sum_{k=1}^{N_i} \mathbf{\Delta U_{v_k}}$$

Et plus précisément, c'est le terme

[Math 68]

$$\mathbf{F_{nl}}(\mathbf{U_S} + \textstyle\sum_{k=1}^{N_i} \mathbf{\Delta U_{v_k}})$$

qui définit le couplage des différents modes entre eux.
Dans les équations Math 67 et Math 68 $\mathbf{F_{nl}}$ représente les efforts non-linéaires de contact et de frottement à l'interface de friction, $J_{nl}$ représente la matrice Jacobienne des efforts non-linéaires autour de la position d'équilibre statique Us représente une position d'équilibre statique, $\Delta U_{vk}$ représente la composante sur la pulsation $\omega_k$ des dépla-

cements ΔU.

Synthèse

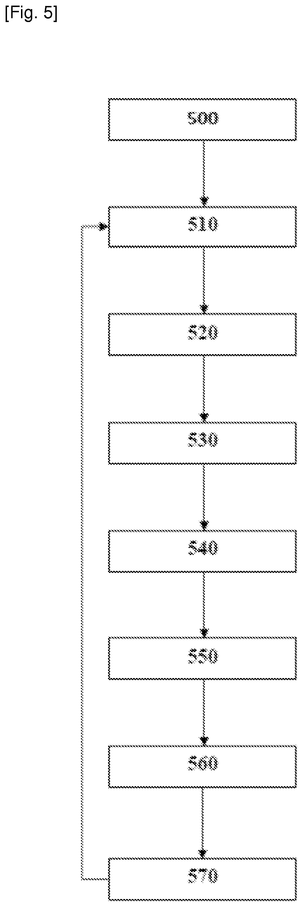

En résumé, un exemple de réalisation d'un procédé de prédiction d'instabilités de crissement d'un système de frein correspondant à la démarche générale de la méthode MASA multi-mode présentée en détail ci-dessus peut être synthétisé en référence à la FIG. 5 de la façon suivante.

Bien que les étapes soient décrites de manière séquentielle, l'homme du métier comprendra que certaines étapes peuvent selon le cas être omises, combinées, exécutées dans un ordre différent et / ou en parallèle.

Etape 500 : on met en oeuvre une méthode d'identification des modes instables au point d'équilibre statique. On utilise par exemple la méthode CEA classique. Les $N_i$ modes instables sont identifiés. La déformée

[Math 69]

$$(\mathbf{\Psi}^0_k)_{k \in [1, N_i]}$$

et pulsation associée à chaque mode instable est obtenu par cette méthode d'identification de modes instables.

Le vecteur d'amplitude modale défini par Math 59 est initialisé une valeur initiale $\mathbf{p}^0 = \mathbf{0}$. Une valeur de perturbation initiale $\Delta\mathbf{p}$ est choisie.

Un processus itératif est mis en oeuvre. A chaque itération, l'indice $m$ est incrémenté. La valeur de $m$ est fixée à 1, $m$ représentant l'indice du temps ou le numéro de la boucle d'itération dans le processus itératif.

Un modèle linéaire du système de frein est généré dans lequel les efforts non-linéaires sont linéarisés vis-à-vis du déplacement et de la vitesse selon des degrés de liberté du système de frein.

En outre, le modèle linéaire du système de frein peut être décomposé en sous-systèmes mécaniques, chaque sous-système correspondant à un mode instable obtenu par la méthode d'identification de modes instables et correspondant à une pulsation ou fréquence. Cela revient à projeter le modèle linéaire initial sur les fréquences des modes instables identifiés.

Une simulation d'une excitation du système de frein est alors mise en oeuvre en imposant un déplacement particulier selon les degrés de liberté du système de frein. Ce déplacement particulier peut s'exprimer sous forme de combinaison linéaire de N déformées modales, une déformée modale correspondant à un mode instable et étant définie par une déformée modale normalisée, une amplitude modale et une fréquence parmi les N fréquences identifiées par la méthode CEA.

A chaque itération, les niveaux des amplitudes modales varient et sont déterminées en fonction de la variable temps à partir de Math 62. Les déformées permettant l'expression des déplacements imposés ainsi que les fréquences associées qui permettent la mise en oeuvre de la méthode AFT, correspondent aux déformées normalisées et aux fréquences identifiées par la méthode CEA.

Puis on détermine, sur la base du modèle linéaire du système de frein, les variations des valeurs propres des matrices d'état des différents sous-systèmes lorsque les niveaux des amplitudes modales varient.

Une identification d'instabilités est ensuite possible sur la base des valeurs propres complexes ainsi calculées.

Du point de vue mathématique, le processus itératif inclut les étapes 510 à 570.

Etape 510 : l'amplitude modale $p_j^m$ est déterminée par récurrence à partir de l'amplitude modale de l'itération précédente $p_j^{m-1}$ sur la base de l'équation Math 62 si $m>1$, ou à partir de la perturbation initiale $\Delta\mathbf{p}$ si $m = 1$.

Etape 520 : à partir de chaque amplitude modale $p_j^m$, les déformées modales non normalisées $X_k^m$ sont déterminées à partir de l'équation Math 60.

Etape 530 : les déplacements $\Delta\mathbf{U}_{Vk}^{C,m}$ et $\Delta\mathbf{U}_{Vk}^{S,m}$ sont calculés à partir des équations Math 53 et Math 54 déclinées pour l'itération m.

Etape 540 : chaque $\Delta\mathbf{U}_{Vk}^m$ est déterminé en appliquant la transformée de Fourier inverse aux $\Delta\mathbf{U}_{V_k}^{C,m}$ et

$$\Delta \mathbf{U}_{V_k}^{S,m}.$$

Etape 550: la somme des efforts non-linéaires $\Omega_{Vk}^m$ pour tous les modes $k= 1$ à $N_i$ est calculée à partir de l'équation Math 67 et exprimés dans l'espace de Fourier.

Etape 560 : les matrices $K_{vk}$ et $C_{vk}$ sont déterminées à partir de l'équation Math 49.

Ce calcul peut s'effectuer de la façon suivante. Pour chaque élément de contact n, la projection sur chaque pulsation $\omega_k$ du déplacement relatif normal s'écrit :

[Math 70]

$$\delta_k^n(t) = \delta_c \cos \omega_k t + \delta_S \sin \omega_k t.$$

Par ailleurs, les efforts dans la direction d, qui peut être tangentielle ou normale, entre deux noeuds en contact sont :

[Math 71]

$$\Omega_{V_k}^{n,d}(t) = \tau_c \cos \omega_k t + \tau_s \sin \omega_k t$$

Ainsi pour chaque direction d, ces efforts doivent vérifier l'équation :

[Math 72]

$$\Omega_{V_k}^{n,d}(t) = k^{n,d} \delta^n(t) + c^{n,d} \dot{\delta}^n(t)$$

la résolution des équations donne :

[Math 73]

$$\begin{cases} \mathbf{k}^{n,d} = \frac{\delta_c \tau_c + \delta_s \tau_s}{\delta_c^2 + \delta_s^2} & \mathbf{c}^{n,d} = \frac{\delta_s \tau_c - \delta_c \tau_s}{\omega(\delta_c^2 + \delta_s^2)} & \text{si } \delta_c \neq 0 \text{ ou } \delta_s \neq 0 \\ \mathbf{k}^{n,d} = 0 & \mathbf{c}^{n,d} = 0 & \text{sinon} \end{cases}$$

Etape 570 : les différentes matrices $\mathbf{A}_k^m$ sont déterminées à partir de l'équation Math 52 et les valeurs propres des différentes matrices $\mathbf{A}_k^m$ sont déterminées.

Les étapes 510 à 570 sont ensuite répétées pour $m= m+1$.

L'analyse de la divergence de chaque mode instable $k$ se fait à partir de l'analyse de l'évolution en fonction du temps de sa valeur propre $\lambda_k$ dans le sous-système $k$. Si une divergence du mode $j$ est observée dans le sous-système $k,$ alors il faut se référer au sous-système $j$ pour voir si cette divergence se traduit effectivement par une divergence dans l'équation du mouvement. Si le mode $j$ était identifié comme stable initialement par la méthode CEA, il serait alors nécessaire d'ajouter ce mode à la base MASA afin de pouvoir statuer sur sa stabilité, c'est-à-dire d'ajouter à une itération donnée (m > 1) une fonction de déformation supplémentaire et pulsation associées à ce mode nouvellement identifié comme instable. En alternative, on peut suivre l'évolution temporelle des valeurs propres des $N_i$ modes instables identifiés au départ par la méthode CEA, puis redémarrer à partir de l'étape 500 une nouvelle simulation avec les $N_s$ instabilités supplémentaires qui apparaissent au cours de la simulation afin d'appliquer à nouveau la méthode MASA sur les Ni + Ns modes instables.

Selon le même principe, il serait envisageable de retirer de l'analyse MASA multi-fréquentielle tout mode dont l'amplitude se serait stabilisée et qui donc ne s'avère pas comme étant instable en régime dynamique. On peut alors retirer à une itération donnée (m > 1) la ou les fonctions de déformation et pulsation associées à tout mode considéré comme stable.

La valeur de perturbation Δp en amplitude modale peut être initialisée de différentes manières. Une valeur trop faible implique un plus grand nombre de calculs nécessaires pour arriver à la stabilisation, une valeur trop élevée peut quant à elle conduire à une divergence de la méthode.

Réduction du modèle éléments finis de frein

Afin de pouvoir appliquer la méthode sur un modèle éléments finis de frein industriel, il est possible de réduire la taille du problème. Ainsi, un modèle réduit tel que celui présenté dans le document FAZIO, O., S. NACIVET et J.-J. SINOU, 2015, «Reduction strategy for a brake system with local frictional non-linearities-application for the prédiction of unstable vibration modes », Applied Acoustics, vol. 91, p. 12-24, est utilisé. Dans cette étude, un processus numérique basé sur une réduction modale pour minimiser la taille du modèle est possible grâce à une modélisation non-linéaire spécifique à l'interface de friction.

Comme expliqué dans ce document, la surface de contact plaquette/disque est réduite en un nombre limité de noeuds sur chaque surface de contact. Ces noeuds sont utilisés par la suite en tant que noeud de condensation et en tant que noeud de définition pour des contacts node-to-node. Une fois la surface réduite générée, le modèle réduit est construit en générant un assemblage de Super Eléments (SE). Pour une description complète de la génération, de la définition et de l'assemblage des SE, le lecteur pourra se référer aux documents FAZIO, O. 2016, Amélioration de la prédictivité des calculs de crissement de frein, thèse de doctorat, Ecole Centrale de Lyon et FAZIO, O., S. NACIVET et J.-J. SINOU. 2015, «Reduction strategy for a brake system with local frictional non-linearities-application for the prédiction of unstable vibration modes », Applied Acoustics, vol. 91, p. 12-24 . De plus, une réduction de Craig et Bampton classique est réalisée où les points de réduction de l'interface plaquette/disque sont conservés comme noeuds de réduction. De cette manière, les efforts non-linéaires de contact peuvent être pris en compte dans le présent modèle.

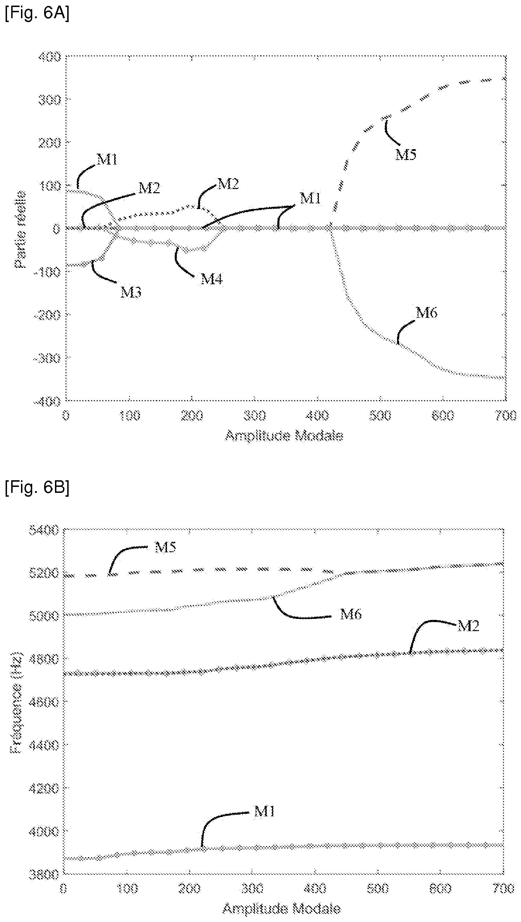

Des exemples de prédiction sont illustrés par référence aux FIGS. 6 à 8 dans des cas dans lesquels un mode instable, non identifiable par la méthode CEA, est détecté grâce à la méthode MASA multi-mode.

Dans l'exemple des FIGS. 6A-6B, la méthode CEA identifie une unique instabilité à 3870 Hz avec une partie réelle de 87. La méthode MASA mono-instable peut être appliquée au départ avec un balayage en amplitude modale. Les évolutions en fonction de l'amplitude modale des parties réelles des valeurs propres et des fréquences obtenues sont représentées respectivement sur la FIG. 6A (parties réelles) et sur la FIG. 6B (fréquences).

On remarque ici que le mode initialement instable (mode M1 représenté en trait plein) voit sa partie réelle s'annuler lorsque les amplitudes de vibration augmentent (vers une valeur de 100 d'amplitude modale). Cependant, avant que ce mode M1 ne se stabilise, un autre mode M2 instable émerge à 4750 Hz environ (mode représenté en traits pointillés). Ainsi, lorsque l'amplitude modale prend une valeur p = 80, deux modes instables sont présents dans le système et pour pouvoir statuer sur le comportement dynamique global et la contribution des modes instables sur la divergence ou atténuation de la réponse dynamique du système, il est nécessaire d'ajouter ce second mode instable à l'analyse MASA.

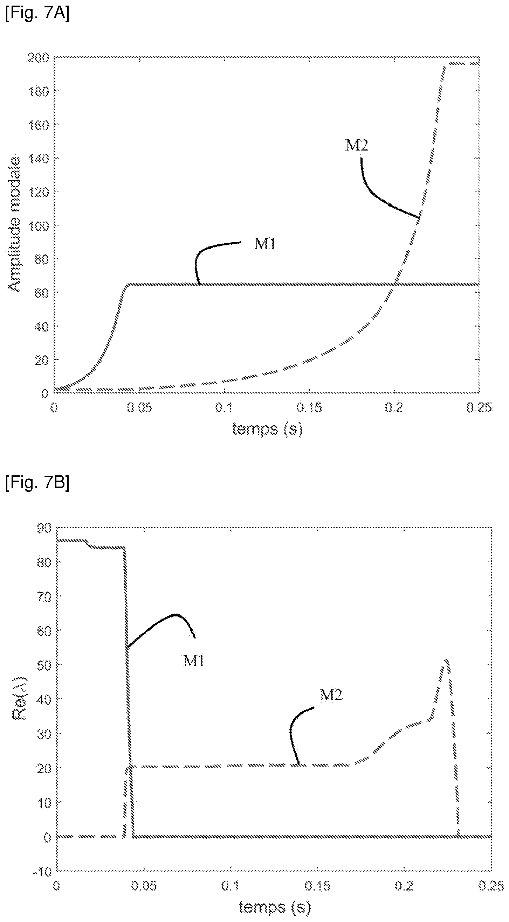

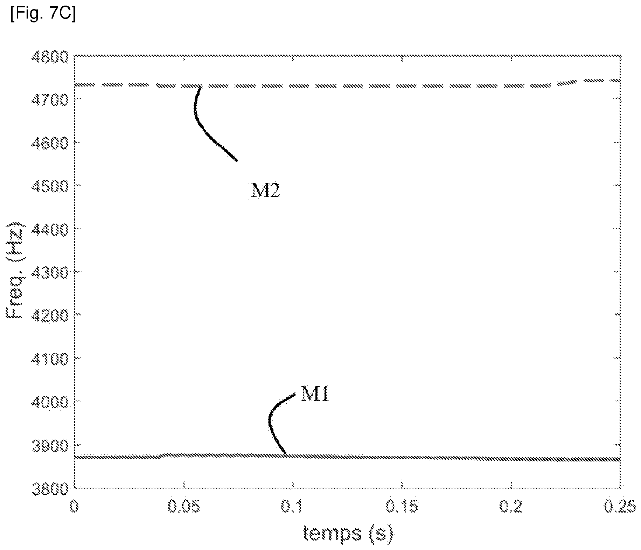

Ainsi, une seconde analyse est réalisée avec la méthode MASA multi-mode (avec deux modes dans ce cas précis). La méthode MASA multi-mode est donc initialisée (étape 500) avec le mode M1 instable et le mode M2 qui devient potentiellement instable. Une faible amplitude modale initiale est affectée initialement aux deux modes instables M1 et M2. Les évolutions temporelles des amplitudes modales (FIG. 7A), des parties réelles des valeurs propres (FIG. 7B) et des fréquences (FIG. 7C) sont représentées dans les FIGS. 7A-7C. Sur ces figures, les courbes d'évolution des paramètres associés au premier mode instable M1 sont en traits pleins, les paramètres associés au mode instable M2 sont en traits pointillés.

Au départ, seul un mode M1 est instable avec une partie réelle de 87 (FIG. 7B) et une fréquence de 3880 Hz (FIG. 7C). Jusqu'à t = 0.045, sa partie réelle reste sensiblement constante et son amplitude modale augmente. Puis, à partir de t = 0.045 s, le second mode M2 voit la partie réelle de sa valeur propre augmenter et devenir positive et le premier mode a sa partie réelle qui s'annule rapidement (cf. FIG. 7B). A partir de t = 0.05 s, le premier mode M1 a une partie réelle nulle et s'est stabilisé à une amplitude d'environ 65 (FIG. 7A). Le second mode M2 a sa partie réelle qui reste constante et égale à 21 (FIG .7B) de t = 0.05 s jusqu'à t = 0.17 s et son amplitude modale augmente progressivement (FIG. 7A). A partir de t = 0.17 s, la partie réelle du second mode M2 augmente à nouveau et croît plus fortement à partir de t = 0.21 s (FIG. 7B). L'amplitude modale associée augmente rapidement (FIG. 7A). Puis à t = 0.22 s, la partie réelle du second mode M2 diminue brusquement et à t = 0.23 s elle s'annule (FIG .7B). L'amplitude modale se stabilise alors à p = 195 (FIG. 7A). La fréquence du second mode M2 est autour de 4730 Hz (FIG. 7C).

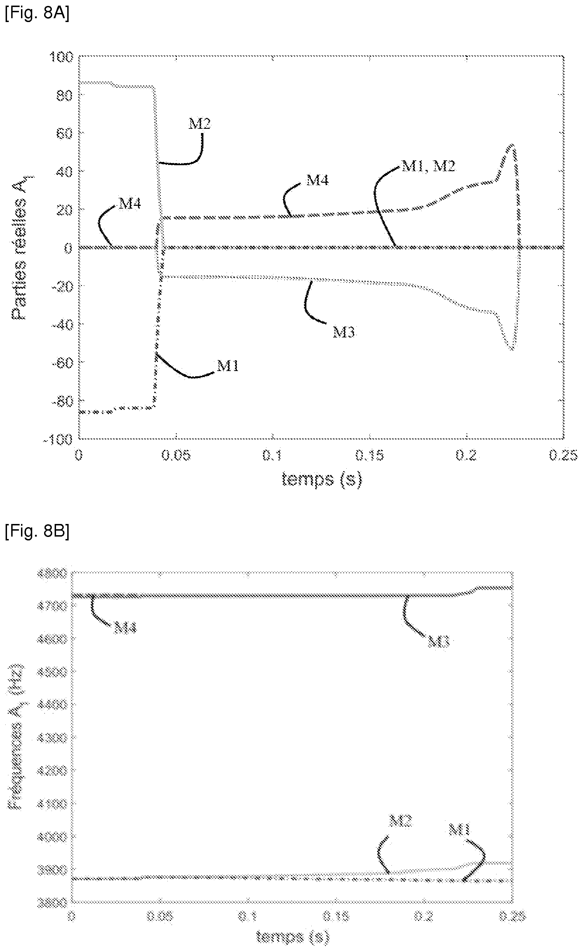

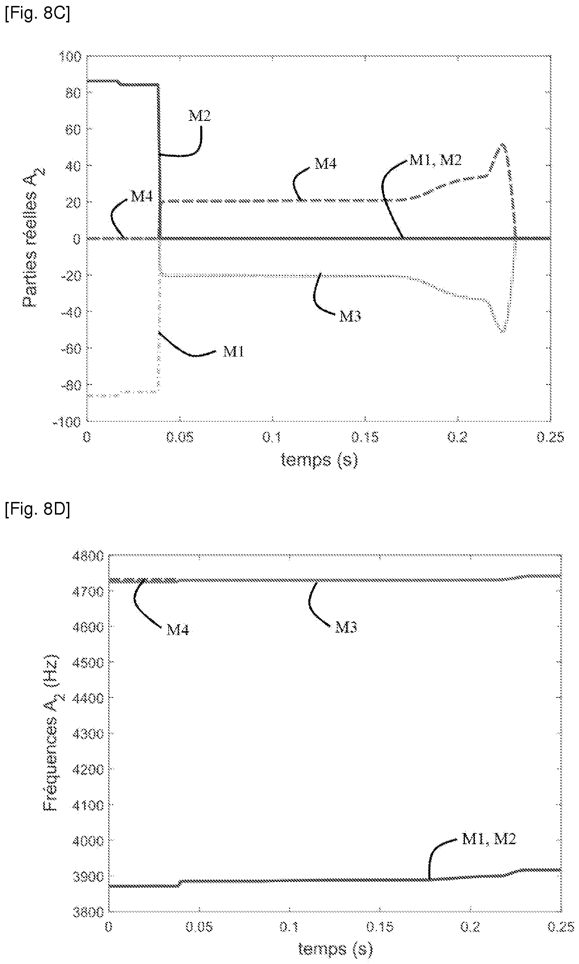

Les évolutions des valeurs propres de deux sous-systèmes sont représentées aux FIGS. 8A-8D. Les évolutions des parties réelles des valeurs propres et fréquences correspondantes sont illustrées pour le premier sous-système correspondant au premier mode instable aux FIGS. 8A et 8B et aux FIGS. 8C et 8D pour le second mode instable correspondant au deuxième sous système.

Les évolutions des valeurs propres des deux sous-systèmes de la FIG. 8 montrent qu'aucune autre instabilité potentielle n'émerge dans l'un des sous-systèmes et qu'il n'est donc pas nécessaire d'appliquer la méthode MASA avec un plus grand nombre d'instabilités.

Les FIGS. 8A-8D correspondent aux valeurs propres des matrices $A_1$ et $A_2$ des deux sous-systèmes, chaque matrice ayant 4 valeurs propres correspondant à chacun des modes, et on représente l'évolution de ces 4 valeurs propres. La participation d'un mode donné dans la réponse globale est donnée par la valeur propre de ce mode dans le sous-système correspondant.

Pour résumer, sur les FIG. 8A-8D on observe que la méthode MASA indique les contributions suivantes :

- t < 0.045 : un seul mode instable M2 à une fréquence d'environ 3880 Hz qui amène une divergence d'amplitude de la réponse vibratoire,
- 0.045 < t < 0.05 : deux modes instables M2 et M4 à des fréquences de 3880 Hz et 4730 Hz qui amènent une divergence en amplitude de la solution,
- 0.05 < t < 0.23 : un mode instable M2 à 3880 Hz à partie réelle nulle et un second mode instable M4 à 4730 Hz qui amène une divergence de la réponse vibratoire du système,
- t > 0.23 : deux modes instables M2 et M4 à 3880 Hz et 4730 Hz à parties réelles nulles qui caractérisent une solution stationnaire quasi-périodique approchée.

Conformément aux résultats présentés sur le modèle académique, il est possible de dire que le système global a une réponse dynamique pilotée par deux modes à 3880 Hz et 4750 Hz avec des amplitudes respectives de 65 et de 195. Ce résultat illustre l'importance de l'utilisation de la méthode MASA multi-modes en complément d'une méthode CEA. En effet, seule une instabilité était détectée avec la méthode CEA alors que deux sont présentes dans la dynamique du système.

Dans certains modes de réalisation, la réponse dynamique stationnaire quasi-périodique du système peut être approchée par :

[Math 75]

$$\mathbf{\Delta U}_1(t) = \mathbf{U_S} + p_1 \mathbf{\Psi}_1^0 e^{i\omega_1^0 t} + p_1 \overline{\mathbf{\Psi}_1^0} e^{-i\omega_1^0 t} + p_2 \mathbf{\Psi}_2^0 e^{i\omega_2^0 t} + p_2 \overline{\mathbf{\Psi}_2^0} e^{-i\omega_2^0 t}$$

avec $p_1 = 65$ et $p_2 = 195$, $\omega_1^0 = 2.44 \ 10^4$ rad/s et $\omega_2^0 = 2.97 \ 10^4$ rad/s et $\Psi_1^0$ et $\Psi_2^0$ étant les déformées modales des deux modes obtenues avec la méthode CEA.

Par ailleurs, ces résultats illustrent aussi l'importance d'utiliser une méthode MASA avec une approche multi-instabilité plutôt que de superposer les résultats de plusieurs approches mono-instables. En effet, dans le cas mono-instable, le premier mode se stabilisait pour une amplitude de 80 alors que l'approche multi-instable prédit une amplitude de 65.

Selon un mode de réalisation, tout ou partie des étapes d'un ou des procédés décrits dans ce document sont mises en oeuvre par un logiciel ou programme d'ordinateur.

Les fonctions et procédés décrits dans ce document peuvent ainsi être mises en oeuvre par logiciel (par exemple, via un logiciel sur un ou plusieurs processeurs, pour exécution sur un ordinateur à usage général (par exemple, via l'exécution par un ou plusieurs processeurs) afin d'implémenter un ordinateur à usage spécifique ou similaire) et/ou puissent être mises en oeuvre dans du matériel (par exemple, en utilisant un ordinateur à usage général, un ou plusieurs circuits intégrés spécifiques (ASIC) et/ou tout autre équivalent matériel).

L'invention concerne ainsi un logiciel ou programme d'ordinateur, susceptible d'être exécuté par un dispositif informatique (par exemple, un ordinateur), au moyen d'un ou plusieurs processeurs de données, ce logiciel / programme comportant des instructions pour cause l'exécution par ce dispositif informatique de tout ou partie des étapes de l'un ou des procédés décrits dans ce document. Ces instructions sont destinées à être stockées dans une mémoire d'un dispositif informatique, chargées puis exécutées par un ou plusieurs processeurs de ce dispositif informatique de sorte à causer l'exécution par ce dispositif informatique du procédé concerné.

Ce logiciel / programme peut être codé au moyen de n'importe quel langage de programmation, et être sous la forme de code source, code objet, ou de code intermédiaire entre code source et code objet, tel que dans une forme partiellement compilée, ou dans n'importe quelle autre forme souhaitable.

Le dispositif informatique peut être mis en oeuvre par une ou plusieurs machines physiquement distinctes. Le dispositif informatique peut présenter globalement l'architecture d'un ordinateur, incluant des constituants d'une telle architecture: mémoire(s) de données, processeur(s), bus de communication, interface(s) matérielle(s) pour la connexion de ce dispositif informatique à un réseau ou un autre équipement, interface(s) utilisateur, etc.

Dans un mode de réalisation, tout ou partie des étapes d'un ou plusieurs procédés décrits dans ce document sont mises en oeuvre par un dispositif doté de moyens de mise en oeuvre de ces étapes du ou des procédés concernés.

Ces moyens peuvent comprendre des moyens logiciels (software) (par ex. des instructions d'un ou plusieurs composants d'un programme) et/ou moyens matériels (hardware) (par ex. mémoire(s) de données, processeur(s), bus de communication, interface(s) matérielle(s), etc).

Des moyens mettant en oeuvre une fonction ou un ensemble de fonctions peuvent également correspondre dans ce document à un composant logiciel, à un composant matériel ou bien à un ensemble de composants matériels et/ou logiciels, apte à mettre en oeuvre la fonction ou l'ensemble de fonctions, selon ce qui est décrit ci-dessous pour les moyens concernés.

L'invention concerne aussi un support d'informations lisible par un processeur de données, et comportant des instructions d'un programme tel que mentionné ci-dessus.

Le support d'informations peut être n'importe quel moyen matériel, entité ou dispositif, capable de stocker les instructions d'un programme tel que mentionné ci-dessus. Les supports de stockage de programme utilisables incluent les mémoires ROM ou RAM, les supports de stockage magnétiques tels que des disques magnétiques et des bandes magnétiques, les disques durs ou des supports de stockage de données numériques à lecture optique, etc ou toute combinaison de ces supports.

Dans certains cas, le support de stockage lisible par ordinateur n'est pas transitoire. Dans d'autres cas, le support d'informations peut être un support transitoire (par exemple, une onde porteuse) pour la transmission d'un signal (signal électromagnétique, électrique, radio ou optique) porteur des instructions de programme. Ce signal peut être acheminé via un moyen de transmission approprié, filaire ou non filaire: câble électrique ou optique, liaison radio ou infrarouge, ou par d'autres moyens.

Un mode de réalisation concerne également un produit programme d'ordinateur comprenant un support de stockage lisible par ordinateur sur lequel sont stockées des instructions de programme, les instructions de programme étant configurées pour causer la mise en oeuvre par le dispositif informatique de tout ou partie des étapes d'un ou des procédés décrits ici lorsque les instructions de programme sont exécutées par un ou plusieurs processeurs et/ou un ou plusieurs composants matériels programmables.

## Revendications

1. Procédé de prédiction d'instabilités de crissement d'une surface de friction d'un système de frein, le procédé étant mis en oeuvre par ordinateur et comprenant

   a. une identification (500) de N modes instables autour d'un point d'équilibre statique, les modes instables étant définis respectivement par N fréquences et N valeurs propres initiales de N modes du système de frein ;
   b. une modélisation (500) du système de frein par un modèle linéaire dans lequel les efforts non-linéaires sont linéarisés vis-à-vis du déplacement et de la vitesse selon des degrés de liberté du système du frein ;
   c. une simulation (510) d'une excitation du système de frein en imposant un déplacement selon lesdits degrés de liberté, le déplacement imposé étant sous forme de combinaison linéaire de N déformées modales, une déformée modale correspondant à un mode instable et étant définie par une amplitude modale de niveau variable et une fréquence parmi les N fréquences;
   d. un calcul (520-570) d'une évolution d'au moins une valeur propre complexe d'au moins une matrice d'état du modèle linéaire lorsque le niveau d'une amplitude modale d'au moins une déformée modale varie;
   e. une identification (570) d'instabilités de crissement du système de frein sur la base de valeurs propres complexes calculées pour les niveaux d'amplitudes modales considérés,

   **caractérisé en ce qu'**une valeur courante d'une amplitude modale est définie en fonction du temps par récurrence par rapport à une valeur courante précédente et une amplitude modale initiale, et le procédé comprend un calcul de l'évolution en fonction du temps des valeurs propres complexes pour les niveaux d'amplitudes modales considérés.

2. Procédé selon la revendication 1 , comprenant le calcul de la partie réelle de chaque valeur propre complexe obtenue et de la fréquence correspondante.

3. Procédé selon l'une quelconque des revendications précédentes, dans lequel une valeur courante $p_k(t_{n+1})$ à l'instant $t_{n+1} = t_n + \delta t$ d'une amplitude modale d'un mode k est définie par rapport à la valeur précédente $p_k(t_n)$ à l'instant $t_n$

et à la valeur propre $\lambda_k^n$ obtenue pour le mode k à l'itération précédente de la façon suivante

$$[\text{Math } 111]$$

$$p_k^{n+1} = p_k^n \exp(\Re(\lambda_k^n)\delta t)$$

**4.** Procédé selon l'une quelconque des revendications précédentes, dans lequel le système de frein est décomposé en sous-systèmes dynamiques et une matrice d'état du modèle linéaire correspond à une instabilité et un sous-système dynamique du système de frein.

**5.** Procédé selon l'une quelconque des revendications précédentes, le procédé comprenant en outre une interruption du calcul de l'évolution des valeurs propres du modèle linéaire sur détermination qu'une nouvelle valeur propre obtenue à l'étape d) ne fait pas partie des N valeurs propres initiales du système de frein et que la partie réelle de la nouvelle valeur propre est positive ; une modification de la modélisation des déplacements de sorte à introduire une fonction de déformation supplémentaire associée à la nouvelle valeur propre et à représenter les déplacements comme combinaison linéaire des N fonctions de déformation et de la fonction de déformation supplémentaire ;une reprise de l'étape d) de calcul de l'évolution des valeurs propres du modèle linéaire sur la base de la modélisation modifiée des déplacements.

**6.** Procédé d'optimisation d'un système de frein, comprenant

une obtention de valeurs de paramètres de conception structurelle du système de frein ;
une génération d'un modèle linaire du système de frein à partir des valeurs obtenues ; une identification d'instabilités de crissement du système de frein en mettant en oeuvre un procédé de prédiction d'instabilités de crissement selon l'une quelconque des revendications précédentes sur la base du modèle linéaire généré ;
une correction d'au moins une valeur d'au moins un paramètre de conception structurelle du système de frein sur la base des instabilités de crissement identifiées ; une correction du modèle linaire du système de frein à partir de ladite au moins une valeur corrigée ;
une identification d'instabilités de crissement du système de frein en mettant en oeuvre un procédé de prédiction d'instabilités de crissement selon l'une quelconque des revendications précédentes sur la base du modèle linéaire corrigé.

**7.** Dispositif comprenant des moyens configurés pour mettre en œuvre les étapes d'un procédé selon l'une quelconque des revendications précédentes.

**8.** Programme d'ordinateur comportant des instructions de programme pour l'exécution des étapes du procédé selon l'une quelconque des revendications 1 à 6 lorsque ledit programme est exécuté par un ordinateur.

**9.** Support d'enregistrement lisible par un ordinateur comprenant des instructions qui, lorsqu'elles sont exécutées par un ordinateur, conduisent celui-ci à mettre en oeuvre le procédé selon l'une des revendications 1 à 6.

**Patentansprüche**

**1.** Verfahren zur Vorhersage von Quietschinstabilitäten einer Reibfläche eines Bremssystems, wobei das Verfahren computerimplementiert ist und umfasst

a. eine Identifizierung (500) von N instabilen Moden um einen Punkt des statischen Gleichgewichts, wobei die instabilen Moden jeweils durch N Frequenzen und N anfängliche Eigenwerte von N Moden des Bremssystems definiert werden;
b. eine Modellierung (500) des Bremssystems unter Verwendung eines linearen Modells, bei dem die nichtlinearen Kräfte in Bezug auf den Weg und die Geschwindigkeit entsprechend den Freiheitsgraden des Bremssystems linearisiert werden;
c. eine Simulation (510) einer Anregung des Bremssystems durch Auferlegen einer Verschiebung gemäß den Freiheitsgraden, wobei die aufgeprägte Verschiebung in Form einer linearen Kombination von N Modalformen vorliegt, wobei eine Modalform einer instabilen Mode entspricht und definiert ist durch eine modale Amplitude mit variablem Pegel und einer Frequenz unter den N Frequenzen;

d. eine Berechnung (520-570) einer Entwicklung mindestens eines komplexen Eigenwerts mindestens einer Zustandsmatrix des linearen Modells, wenn das Niveau einer Modalamplitude mindestens einer Modalform variiert;

e. eine Identifizierung (570) von Quietschinstabilitäten des Bremssystems auf Basis komplexer Eigenwerte, die für die betrachteten modalen Amplitudenniveaus berechnet wurden.

2. Verfahren nach Anspruch 1, das die Berechnung des Realteils jedes erhaltenen komplexen Eigenwerts und der entsprechenden Frequenz umfasst.

3. Verfahren nach einem der vorhergehenden Ansprüche, bei dem ein aktueller Wert $p_k(t_{n+1})$ zum Zeitpunkt $t_{n+1} = t_n + \delta t$ einer Modalamplitude einer Mode k durch Vergleich mit dem vorherigen definiert wird Wert $p_k(t_n)$ zum Zeitpunkt $t_n$ und auf den Eigenwert, $\lambda_k^n$ der für Modus k bei der vorherigen Iteration erhalten wurde, auf folgende Weise

[Mathe 111]

$$p_k^{n+1} = p_k^n \exp(\Re(\lambda_k^n)\delta t)$$

4. Verfahren nach einem der vorhergehenden Ansprüche, wobei das Bremssystem in dynamische Teilsysteme zerlegt wird und eine Zustandsmatrix des linearen Modells einer Instabilität und einem dynamischen Teilsystem des Bremssystems entspricht.

5. Verfahren nach einem der vorhergehenden Ansprüche, wobei das Verfahren weiterhin eine Unterbrechung der Berechnung der Entwicklung der Eigenwerte des linearen Modells umfasst, wenn festgestellt wird, dass ein in Schritt d) erhaltener neuer Eigenwert nicht einer der N anfänglichen Eigenwerte ist des Bremssystems und dass der Realteil des neuen Eigenwerts positiv ist; eine Modifikation der Modellierung der Verschiebungen, um eine zusätzliche Verformungsfunktion einzuführen, die mit dem neuen Eigenwert verknüpft ist, und die Verschiebungen als lineare Kombination der N Verformungsfunktionen und der zusätzlichen Verformungsfunktion darzustellen; eine Wiederaufnahme von Schritt d) der Berechnung der Entwicklung der Eigenwerte des linearen Modells auf der Grundlage der modifizierten Modellierung der Verschiebungen.

6. Verfahren zur Optimierung eines Bremssystems, umfassend das Erhalten von Werten struktureller Designparameter des Bremssystems; das Erzeugen eines linearen Modells des Bremssystems aus den erhaltenen Werten; das Identifizieren von Quietschinstabilitäten des Bremssystems durch Implementierung eines Verfahrens zur Vorhersage des Quietschens Instabilitäten nach einem der vorhergehenden Ansprüche auf Basis des generierten linearen Modells; eine Korrektur mindestens eines Wertes mindestens eines Strukturdesignparameters des Bremssystems auf Basis der identifizierten Quietschinstabilitäten; eine Korrektur des linearen Modell des Bremssystems aus dem mindestens einen korrigierten Wert; eine Identifizierung von Quietschinstabilitäten des Bremssystems durch Implementierung eines Verfahrens zur Vorhersage von Quietschinstabilitäten nach einem der vorhergehenden Ansprüche auf der Grundlage des korrigierten linearen Modells.

7. Vorrichtung, die Mittel umfasst, die zum Implementieren von Schritten eines Verfahrens nach einem der vorhergehenden Ansprüche konfiguriert sind.

8. Computerprogramm, das Programmanweisungen zum Ausführen der Schritte eines Verfahrens nach einem der Ansprüche 1 bis 6 umfasst, wenn das Programm von einem Computer ausgeführt wird.

9. Computerlesbares Aufzeichnungsmedium mit Anweisungen , die, wenn sie von einem Computer ausgeführt werden, diesen veranlassen, das Verfahren nach einem der Ansprüche 1 bis 6 auszuführen

**Claims**

1. Method for predicting squealing instabilities of a friction surface of a brake system, the method being implemented by computer and comprising

   a. an identification (500) of N unstable modes around a point of static equilibrium, the unstable modes being defined respectively by N frequencies and N initial eigenvalues of N modes of the brake system;
   b. a modeling (500) of the brake system using a linear model in which the nonlinear forces are linearized with respect to the displacement and the speed according to the degrees of freedom of the brake system;
   c. a simulation (510) of an excitation of the brake system by imposing a displacement according to said degrees of freedom, the imposed displacement being in the form of a linear combination of N modal shapes, a modal shape corresponding to an unstable mode and being defined by a modal amplitude of variable level and one frequency among the N frequencies;
   d. a calculation (520-570) of an evolution of at least one complex eigenvalue of at least one state matrix of the linear model when the level of a modal amplitude of at least one modal shape varies;
   e. an identification (570) of squeal instabilities of the brake system on the basis of complex eigenvalues calculated for the modal amplitude levels considered.

2. Method according to claim 1, comprising calculating the real part of each complex eigenvalue obtained and the corresponding frequency.

3. Method according to any one of the preceding claims, in which a current value $p_k(t_{n+1})$ at time $t_{n+1} = t_n + \delta t$ of a modal amplitude of a mode k is defined by compared to the previous value $p_k(t_n)$ at time $t_n$ and to the eigenvalue $\lambda_k^n$ obtained for mode k at the previous iteration in the following way

[Math 111]

$$p_k^{n+1} = p_k^n \exp(\Re(\lambda_k^n)\delta t)$$

4. Method according to any one of the preceding claims, wherein the brake system is decomposed into dynamic subsystems and a state matrix of the linear model corresponds to an instability and a dynamic subsystem of the brake system.

5. Method according to any one of the preceding claims, the method further comprising an interruption of the calculation of the evolution of the eigenvalues of the linear model upon determination that a new eigenvalue obtained in step d) is not one of the N initial eigenvalues of the brake system and that the real part of the new eigenvalue is positive; a modification of the modeling of the displacements so as to introduce an additional deformation function associated with the new eigenvalue and to represent the displacements as a linear combination of the N deformation functions and the additional deformation function; a resumption of step d) of calculating the evolution of the eigenvalues of the linear model on the basis of the modified modeling of the displacements.

6. Method for optimizing a brake system, comprising obtaining values of structural design parameters of the brake system; generating a linear model of the brake system from the values obtained; identifying squeal instabilities of the brake system by implementing a method for predicting squealing instabilities according to any one of the preceding claims on the basis of the generated linear model; a correction of at least one value of at least one structural design parameter of the brake system on the basis of the squeal instabilities identified; a correction of the linear model of the brake system from said at least one corrected value; an identification of squeal instabilities of the brake system by implementing a method of prediction of squeal instabilities according to any one of the preceding claims on the basis of the corrected linear model.

7. Device comprising means configured to implement steps of a method according to any one of the preceding claims.

8. Computer program comprising program instructions for executing the steps of a method according to any one of claims 1 to 6 when said program is executed by a computer.

9. Computer-readable recording medium comprising instructions which, when executed by a computer, cause it to implement the method according to one of claims 1 to 6

[Fig. 1]

[Fig. 2]

[Fig. 3]

$\Delta U(t)$

$\Delta U(0)$

[Fig. 2]

[Fig. 4]

EP 3 891 647 B1

[Fig. 5]

31

[Fig. 6A]

[Fig. 6B]

[Fig. 7A]

[Fig. 7B]

[Fig. 7C]

[Fig. 8A]

[Fig. 8B]

[Fig. 8C]

[Fig. 8D]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3039645 B1

- FR 2988503 B1

**Littérature non-brevet citée dans la description**

- **CEA.** *Complex Eigenvalue Analysis*
- **DE MOIROT, FRANCK.** *Etude de la stabilité d'un équilibre en présence de frottement de Coulomb. Application au crissement des freins à disque,* 1998
- **NACIVET, S ; J.-J. SINOU.** intitule «Modal amplitude stability analysis and its application to brake squeal. *Applied Acoustics,* 2017, vol. 116, 127-138
- **FAZIO et al.** *Applied Acoustics,* 15 Avril 2015, vol. 91, 12-24
- **CAMERON, T. M. ; GRIFFIN, J. H.** An alternating frequency/time domain method for calculating the steady-state response of nonlinear dynamic systems. *Journal of applied mechanics,* 1989, vol. 56 (1), 149-154

- **FAZIO, O. ; S. NACIVET ; J.-J. SINOU.** Reduction strategy for a brake system with local frictional non-linearities-application for the prédiction of unstable vibration modes. *Applied Acoustics,* 2015, vol. 91, 12-24
- **FAZIO, O.** *Amélioration de la prédictivité des calculs de crissement de frein,* 2016
- **LYON ; FAZIO, O. ; S. NACIVET ; J.-J. SINOU.** Reduction strategy for a brake system with local frictional non-linearities-application for the prédiction of unstable vibration modes. *Applied Acoustics,* 2015, vol. 91, 12-24